# NOUVEAU FASCICULE DE BREVET EUROPEEN

(11) **EP 0 322 320 B2**
(45) Date de publication et mention de la décision concernant l'opposition: **25.08.1999**
(45) Mention de la délivrance du brevet: 29.12.1993
(21) Numéro de dépôt: 88403290.5
(22) Date de dépôt: 22.12.1988
(51) Int. Cl.: G06K 19/07

(54) **Structure de carte à puce**
Chipkartenstruktur
Chip card structure

(30) Priorité: 22.12.1987 FR 8717902
(43) Date de publication de la demande: 28.06.1989
(73) Titulaire: GEMPLUS CARD INTERNATIONAL, F-13100 Aix en Provence (FR)
(72) Inventeur: Gloton, Jean-Pierre Cabinet Ballot-Schmit, F-75116 Paris (FR); Coiton, Gérard Cabinet Ballot-Schmit, F-75116 Paris (FR)
(74) Mandataire: Ballot, Paul Denis Jacques

(56) Documents cités:
- EP-A- 0 207 853
- EP-A- 0 246 973
- DE-A- 3 528 686
- FR-A- 2 538 930
- GB-A- 2 096 541

## Description

L'invention concerne la fabrication de cartes contenant des circuits-intégrés, plus généralement connues sous le nom de cartes à puce ou encore cartes comportant un composant.

Ces cartes, maintenant largement répandues pour des applications telles que le prépaiement de communications téléphoniques dans les cabines publiques, sont utilisées par le grand public et sont soumises à des contraintes mécaniques d' autant plus sévères que les utilisateurs doivent transporter ces cartes avec eux pratiquement en permanence afin de pouvoir en disposer dès qu'ils en ont besoin.

Or, pour éviter que ces cartes ne soient trop encombrantes, on s'arrange pour leur donner des formats très plats. L'idéal est pour le moment le format des cartes de crédit de quelques centimètres de côté (une dizaine de cm de long et la moitié de large) et de 1 à 2 millimètres environ d'épaisseur.

Cette faible épaisseur rend les cartes flexibles. Or le circuit intégré qui est à l'intérieur est monté sous forme d'un micromodule placé à l'intérieur d'une cavité ménagée dans la carte et solidarisé de la carte par une opération de chauffage. Pendant cette opération, la colle thermoplastique enrobant le circuit-intégré dans le micromodule fond partiellement et vient adhérer à la matière plastique constituant la carte.

L'adhérence du micromodule à la carte est donc essentiellement due à cette opération de chauffage, qui peut aussi être une opération de collage du micromodule au fond de la cavité. Le micromodule n'est pas autrement maintenu dans la cavité car il ne faut pas oublier que les bornes de connexion de la carte à puce sont réalisées sur le micromodule lui-même et que ces connexions doivent affleurer essentiellement dans le plan de la surface supérieure de la carte.

On connait par les documents FR-A-2 538 930 et EP-A-0 207 853 des systèmes de fixation de micromodules dans les cartes. FR-A-2 538 930 décrit une carte à puce dont le micromodule est retenu par des pions de baïonnette au fond du micromodule. EP-A-0 207 853 qui couvre le préamble de la revendication 1 une carte à puce ou la puce est fixée par collage d'un support isolant auquel la puce est connectée. Cependant, ces systèmes de fixation présentent des problèmes de tenue naturelle ainsi que des problèmes d'arrachage.

Le document DE 35 28 686 A1 décrit les caractéristiques définies au préambule de la revendication 1.

On a constaté qu'il existait un risque non négligeable d'arrachage du micromodule en cas de flexion trop importante de la carte. Cet arrachage, même partiel, peut empêcher ensuite l'utilisation de la carte.

Une méthode pour réduire ce risque a été adoptée de manière très générale : elle consiste à placer le micromodule dans un coin et non au centre de la carte car les déformations relatives des zones de la carte en cas de flexion ou torsion sont moindres sur les bords qu'au centre de la carte.

Mais cette mesure n'est pas suffisante et l'invention se propose d'améliore la fabrication des cartes à puces pour réduire encore le risque d'arrachage du micromodule en cas de flexion de la carte.

Pour cela, l'invention propose une structure telle que définie à la revendication 1 et un procédé tel que revendiqué à la revendication 5.

II est placé de préférence dans la zone de la cavité qui subit les plus grandes déformations en cas de flexion de la carte.

On peut envisager éventuellement un surplomb au dessus de chacun des coins de la cavité.

Dans beaucoup de cas, la carte peut être réalisée par colaminage de feuilles de matière plastique (chlorure de polyvinyle par exemple), chacune de ces feuilles étant prédécoupée pour constituer, par superposition des découpes, la cavité; dans ce cas, on peut aussi réaliser le surplomb au moyen d'une découpe de forme particulière de la feuille supérieure de la superposition.

On peut aussi envisager que la carte et sa cavité soient réalisées par moulage par transfert d'une résine thermoplastique ou thermodurcissable. Dans ce cas, on prévoit de préférence que le moule définit une forme avec une bosse à au moins un emplacement sur le bord de la cavité; après mise en place du micromodule dans la cavité, cette bosse est aplatie à chaud pour former le surplomb recouvrant partiellement un bord du micromodule pour aider à son maintien.

D'autres caractéristiques et avantages de l'invention apparaîtront à la lecture de la description détaillée qui suit et qui est faite en référence aux dessins annexés dans lesquels:
- la figure 1 représente l'aspect général classique d'une carte à puce de format carte de crédit;
- la figure 2 représente en vue agrandie la disposition d'un micromodule de circuit-intégré à l'intérieur d'une cavité ménagée dans la carte;
- la figure 3 représente la structure de carte selon un mode de réalisation de l'invention;
- la figure 4 représente une vue de dessus partielle correspondant à la figure 3;
- la figure 5 représente schématiquement deux phases d'un procédé de réalisation du surplomb selon l'invention par écrasement d'un bossage de la carte.

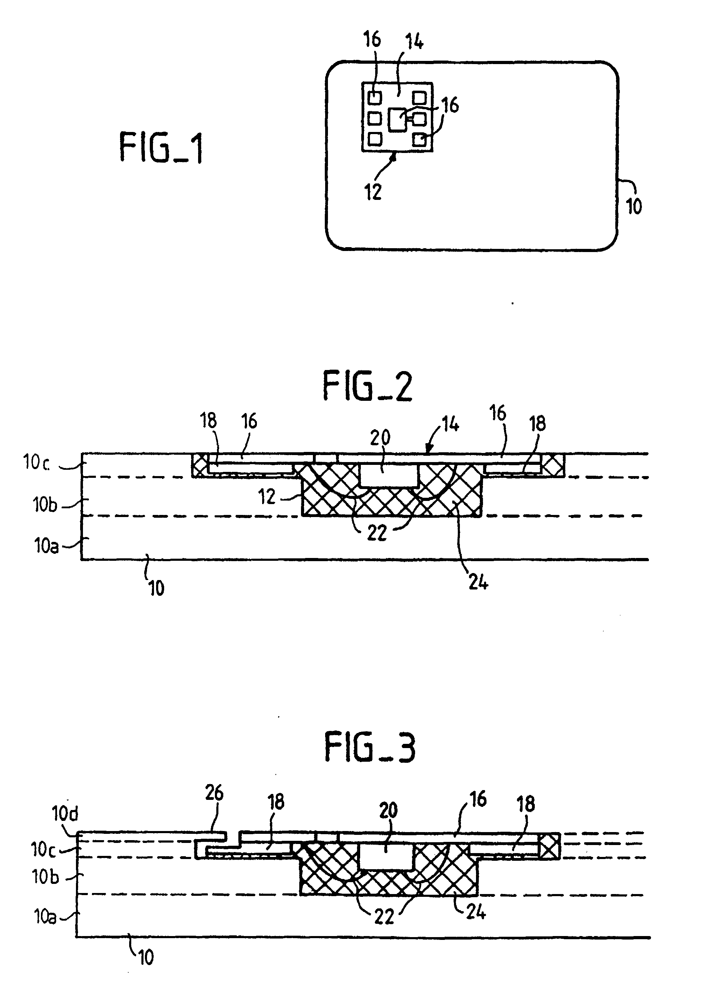

A la figure 1, on a représenté une carte à puce 10 de format classique ISO, rectangulaire, d'environ dix centimètres de long, cinq de large, et 1 à 2 millimètres d'épaisseur.

Dans le coin supérieur gauche de la carte est prévue une cavité 12, circulaire ou carrée ou rectangulaire, contenant un micromodule incorporant un circuit intégré et des bornes de connexion dénudées par lesquelles on peut connecter la carte à un appareil de lecture non représenté.

Le micromodule est désigné par la référence 14; les bornes de connexion par la référence 16.

En pratique, le micromodule est réalisé à partir d'un circuit imprimé comportant des conducteurs photogravés sur un substrat isolant. Le substrat est découpé en son centre pour permettre le montage d'une puce de circuit-intégré qui sera reliée aux différentes bornes de connexion du circuit imprimé.

La figure 2 représente une coupe agrandie de la carte 10, avec sa cavité 12 et le micromodule logé à l'intérieur de la cavité. La carte est en matière plastique, par exemple en chlorure de polyvinyle (PVC) ou en une autre matière thermoplastique ou thermodurcissable. Elle peut être réalisée par superposition de feuilles minces collées les unes sur les autres, telles que des feuilles 10a, 10b, 10c sur la figure 2; chaque feuille est alors prédécoupée avant collage sur les autres pour que la superposition des feuilles constitue la cavité 12. Sur la figure 2, la feuille 10a n'est pas découpée, la feuille 10b comporte une découpe dont les dimensions permettent de loger essentiellement la puce de circuit-intégré et les fils qui la relient aux bornes de connexion 16 de la carte ; enfin, la feuille 10c comporte une découpe plus grande que celle de la feuille 10b, pour loger la partie supérieure du micromodule 1.

La carte pourrait aussi être moulée par injection de résine à chaud et sous pression dans un moule dont la forme définit non seulement le volume extérieur de la carte mais aussi la cavité 12.

Le micromodule est réalisé à partir d'un circuit imprimé, c'est-à-dire d'un substrat isolant 18 (en polyimide par exemple), revêtu d'une couche conductrice photogravée constituant les bornes de connexion 16 accessibles de l'extérieur de la carte. Si on appelle face avant du circuit imprimé la face portant les conducteurs de connexion, alors, le substrat isolant 18 est situé à l'intérieur de la cavité 12 et les bornes de connexion affleurent à l'extérieur dans le plan de la surface supérieure de la carte. Le substrat isolant 18 est découpé en son centre pour laisser place à une puce de circuit-intégré 20 qui est située à l'intérieur de la cavité, sous les conducteurs de connexion 16.

De préférence, la puce est soudée à l'arrière de l'une des bornes de connexion, par exemple une borne constituant la masse électrique de la carte, et elle est reliée par des fils de liaison 22, par exemple des fils d'or ou d'aluminium, aux autres bornes de connexion 16.

La puce 20 et les fils de liaison 22 sont enrobés dans une résine de protection 24. La résine ne recouvre pas la face avant des bornes de connexion puisqu'elles doivent rester accessibles. C'est l'ensemble de la puce 20, des fils de liaison 22, du substrat isolant 18, des bornes de connexion 16, et de la résine d'enrobage 24, qui constitue le micromodule 14.

Dans la technique antérieure, le micromodule est mis en place dans une cavité qui va en s'évasant du bas vers le haut, c'est-à-dire que les dimensions de la cavité vont en croissant à mesure qu'on se déplace du fond de la cavité vers le haut donc vers la face supérieure de la carte.

Le micromodule est maintenu en place dans la cavité par la seule adhérence de la résine contre le fond de la cavité; cette adhérence est obtenue par chauffage de la résine après mise en place du module, ou par simple collage.

Selon l'invention, on propose une structure telle que celle de la figure 3, dans laquelle les bords de la cavité présentent au moins un surplomb recouvrant une partie du module pour limiter son déplacement vers le haut.

Le surplomb est désigné par la référence 26. Les autres références de la figure 3 désignent des éléments identiques à ceux de la figure 2. Le surplomb est réalisé à un endroit où l'arrachage du module a le plus de chance de se produire en cas de flexion ou torsion de la carte. Par exemple, un surplomb est prévu en deux coins de la cavité, ces coins étant alignés selon une direction voisine d'une diagonale de la carte. Mais les surplombs peuvent aussi être répartis différemment, par exemple chacun au milieu d'un bord de la cavité.

Le surplomb peut être réalisé de différentes manières, en particulier en fonction du mode de fabrication de la carte. Par exemple, si la carte est réalisée par superposition de feuilles de matière plastique pressées à chaud et découpées de telle sorte que la superposition des feuilles constitue la cavité, on peut prévoir que la feuille supérieure de l'empilement présente une découpe telle que la superposition de l'avant dernière feuille et de la dernière feuille forme un surplomb de la dernière feuille au dessus de la découpe de l'avant dernière feuille. Sur la figure 3, on a représenté un empilement de quatre feuilles 10 a, 10b, 10c, 10d; l'avant dernière feuille est donc la feuille 10c et la dernière feuille est la feuille 10d pourvue du surplomb 26.

Comme il est particulièrement souhaitable que la face avant des bornes de connexion 16 soit exactement dans le plan de la face supérieure de la carte 10, on a prévu que le surplomb 26 vient recouvrir le support isolant à un endroit où celui-ci n'est pas recouvert par le métal des bornes de connexion. Cela permet que le surplomb ne dépasse pas en hauteur la face avant des bornes de connexion, à condition toutefois que l'épaisseur du plastique dans la zone de surplomb ne dépasse pas l'épaisseur de la couche de conducteurs de connexion 16. On pourrait aussi prévoir que le substrat isolant 18 n'est pas plan mais présente un décrochement vers le bas qui lui permet de se glisser sous le surplomb 26 tout en laissant le surplomb et les bornes de connexion dans le même plan que la face supérieure de la carte.

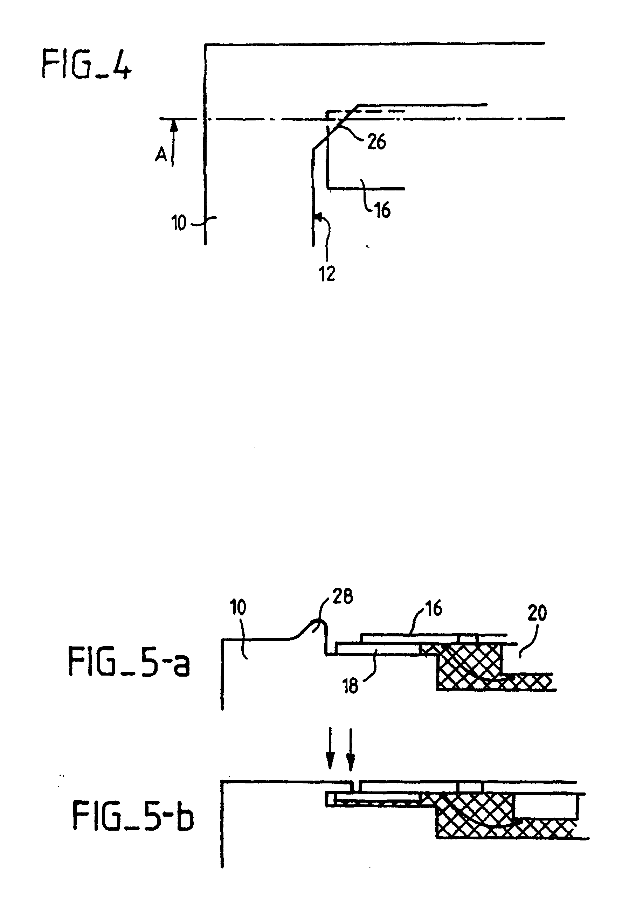

A titre d'exemple seulement, la figure 4 représente une vue de dessus de la carte montrant quelle peut être la disposition du surplomb 26 dans un coin de la cavité 12.

Un autre mode de réalisation du surplomb est utilisable tout particulièrement dans le cas de cartes réalisées par moulage; cette réalisation est schématisée à la figure 5. Elle consiste à prévoir que le moule qui donne sa forme à la carte 10 possède une forme apte à définir
- d'une part le volume général de la carte (format carte de crédit plate);
- d'autre part la cavité 12 pour loger le micromodule 14;
- enfin au moins un bossage 28 sur un bord de la cavité, ce bossage s'étendant vers le haut et non vers l'intérieur de la cavité.

Après introduction du micromodule dans la cavité, on écrase à chaud le bossage jusqu'à le ramener dans le plan de la face supérieure de la carte. On forme ainsi le surplomb 26 en même temps que la résine d'enrobage du micromodule vient adhérer sous l'effet de la chaleur contre la matière plastique du fond de la cavité 12. On peut aussi envisager de rabattre les bossages par une technologie à ultrasons, assurant le ramollissement et la déformation des coins par vibrations à fréquence ultrasonore.

On peut également prévoir que la matière formant les bossages rabattus est légèrement conductrice (par exemple par adjonction de fibres métalliques) pour favoriser l'élimination des charges électrostatiques qui peuvent endommager le circuit-intégré.

Enfin, dans certains cas, on pourra donner aux bossages rabattus une forme permettant de conserver une amovibilité au micromodule : le micromodule serait enclipsable dans la cavité pourvue de bossages rabattus.

## Revendications

1. Carte à puce plate comportant une cavité(12) ménagée dans le corps (10) de la carte et un micromodule (14) logé dans cette cavité, le micromodule comportant deux parties: d'une part un substrat isolant plan (18) recouvert de connexions galvaniques (16) et d'autre part un bloc, formé par une puce (20) enrobée (24) et fixé à ce substrat, la puce enrobée comportant un circuit intégré relié aux connexions du substrat, la puce étant d'une taille donnée, le substrat surmontant le bloc, afin que les connexions affleurent dans le plan de la surface supérieure de la carte lorsque le micromodule est monté dans la cavité, le substrat étant de taille plus grande que la puce, les bords de la cavité présentant au moins une zone de surplomb (26) recouvrant partiellement un bord du substrat de façon à limiter le déplacement de ce micromodule vers l'extérieur de la cavité, caractérisée en ce que la zone de surplomb (26) est limitée à des coins de la cavité, celle-ci ayant une forme rectangulaire ou carrée.

2. Carte à puce selon la revendication 1, caractérisée en ce que le surplomb est limité à deux coins de la cavité, ces coins étant alignés selon une direction voisine d'une diagonale de la carte.

3. Carte à puce selon l'une des revendications 1 et 2, caractérisée en ce que la carte est réalisée par pressage de feuilles de matière plastique (10a à 10d) superposées, certaines des feuilles étant découpées pour former la cavité (12) et la dernière feuille (10d) de la superposition présentant un découpage de forme particulière définissant par rapport au découpage de la feuille précédente le surplomb désiré.

4. Carte à puce selon l'une des revendications 1 à 3, caractérisée en ce que les surplombs sont réalisés dans un matériau légèrement conducteur.

5. Procédé de réalisation d'une carte à puce plate comportant une cavité (12) ménagée dans le corps (10) de la carte et un micromodule (14) logé dans cette cavité, le micromodule comportant deux parties: d'une part un substrat isolant plan (18) recouvert de connexions galvaniques (16) et d'autre part un bloc, formé par une puce (20) enrobée (24) et fixé à ce substrat, la puce enrobée comportant un circuit-intégré relié aux connexions du substrat, la puce étant d'une taille donnée, le substrat surmontant le bloc, afin que les connexions affleurent dans le plan de la surface supérieure de la carte lorsque le micromodule est monté dans la cavité, le substrat étant de taille plus grande que la puce, les bords de la cavité présentant au moins une zone de surplomb (26) recouvrant partiellement un bord du substrat de façon à limiter le déplacement de ce micromodule vers l'extérieur de la cavité, caractérisé en ce qu'il consiste à :
- mouler de la résine pour définir la cavité et un bossage (28), le bossage s'étendant vers le haut de cette cavité, sur un bord de celle-ci,
- puis à écraser le bossage au dessus d'un bord du substrat du micromodule, après que celui-ci ait été mis en place dans la cavité, pour former la zone de surplomb.

6. Procédé selon la revendication 5, caractérisé en ce que les surplombs rabattus sont réalisés de manière à présenter une configuration permettant un enclipsage amovible du micromodule.

7. Procédé selon l'une des revendications 5 à 6, caractérisé en ce que les surplombs rabattus sont réalisés dans un matériau légèrement conducteur.

8. Procédé selon l'une des revendications 5 à 7 caractérisé en ce que les surplombs rabattus sont réalisés dans des coins de la cavité.

## Patentansprüche

1. Flache Chipkarte mit einem im Körper der Karte gebildeten Hohlraum (12) und einem in diesem Hohlraum untergebrachten Mikromodul (14), wobei der Mikromodul zwei Teile aufweist: einerseits ein ebenes isolierendes Substrat (18), das mit galvanischen Anschlüssen (16) bedeckt ist, und andrerseits einen Block, der von einem umhüllten (24) Chip (20) gebildet und an diesem Substrat befestigt ist, wobei der umhüllte Chip eine integrierte Schaltung enthält, die mit den Anschlüssen des Substrats verbunden ist, wobei der Chip eine gegebene Größe hat und wobei das Substrat über den Block hinausragt, damit die Anschlüsse mit der Ebene der oberen Fläche der Karte glatt abschließen, wenn der Mikromodul in dem Hohlraum angebracht ist, wobei das Substrat größer als der Chip ist, wobei die Ränder des Hohlraums wenigstens eine überhängende Zone (26) aufweisen, die einen Rand des Sugbstrats teilweise überdeckt, um die Verlagerung des Mikromoduls aus dem Hohlraum heraus zu begrenzen, dadurch gekennzeichnet, daß die überhängende Zone (26) auf Ecken des Hohlraums begrenzt ist, der eine rechteckige oder quadratische Form hat.

2. Chipkarte nach Anspruch 1, dadurch gekennzeichnet, daß der Überhang auf zwei Ecken des Hohlraums begrenzt ist, wobei diese Ecken in einer einer Diagonale der Karte angenäherten Richtung ausgerichtet sind.

3. Chipkarte nach einem der Ansprüche 1 und 2, dadurch gekennzeichnet, daß die Karte durch Pressung von aufeinandergestapelten Kunststoffolien (10a bis 10d) gebildet ist, wobei einige der Folien zur Bildung des Hohlraums (12) ausgeschnitten sind und die letzte Folie (10d) des Stapels einen Ausschnitt von besonderer Form aufweist, der gegenüber dem Ausschnitt der vorhergehenden Folie den gewünschten Überhang ergibt.

4. Chipkarte nach einem der Anspruche 1 bis 3, dadurch gekennzeichnet, daß die Überhänge aus einem geringfügig leitenden Material gebildet sind.

5. Verfahren zur Herstellung einer flachen Chipkarte mit einem im Körper der Karte gebildeten Hohlraum und einem in diesem Hohlraum untergebrachten Mikromodul (14), wobei der Mikromodul zwei Teile aufweist: einerseits ein ebenes isolierendes Substrat (18), das mit galvanischen Anschlüssen (16) bedeckt ist, und andrerseits einen Block, der von einem umhüllten (24) Chip (20) gebildet und an diesem Substrat befestigt ist, wobei der umhüllte Chip eine integrierte Schaltung enthält, die mit den Anschlüssen des Substrats verbunden ist, wobei der Chip eine gegebene Größe hat und wobei das Substrat über den Block hinausragt, damit die Anschlüsse mit der Ebene der oberen Fläche der Karte glatt abschließen, wenn der Mikromodul in dem Hohlraum angebracht ist, wobei das Substrat größer als der Chip ist, wobei die Ränder des Hohlraums wenigstens eine überhängende Zone (26) aufweisen, die einen Rand des Sugbstrats teilweise überdeckt, um die Verlagerung des Mikromoduls aus dem Hohlraum heraus zu begrenzen, dadurch gekennzeichnet, daß es darin besteht :
- Harz zu formen, um den Hohlraum und einen Höcker zu bilden, wobei der Höcker zur Oberseite des Hohlraums an einem Rand dieses ragt,
- den Höcker dann über einem Rand des Substrats des Mikromoduls zusammenzudrücken, nachdem dieser in dem Hohlraum angebracht worden ist, um die Überhangzone zu bilden.

6. Verfahren nach Anspruch 5, dadurch gekennzeichnet, daß die umgelegten Überhänge eine Gestaltung haben, die ein lösbares Einrasten des Mikromoduls ermöglicht.

7. Verfahren nach einem der Ansprüche 5 und 6, dadurch gekennzeichnet, daß die umgelegten Überhänge aus einem geringfügig leitenden Material gebildet sind.

8. Verfahren nach einem der Ansprüche 5 bis 7, dadurch gekennzeichnet, daß die umgelegten Überhänge in den Ecken des Hohlraums gebildet sind.

## Claims

1. Flat chip card, comprising a cavity (12), which is provided in the body (10) of the card, and a micromodule (14), which is accommodated in this cavity, the micromodule comprising two parts, i.e. firstly a flat isolating substrate (18), which is covered with galvanic connections (16), and secondly a block, which is formed by a chip (20), which is encased (24) and is secured to this substrate, the encased chip comprising an integrated circuit, which is connected to the connections of the substrate, the chip being of a specific size, the substrate surmounting the block, such that the connections are flush with the plane of the upper surface of the card, when the micromodule is fitted in the cavity, the substrate being of a size which is larger than the chip, the edges of the cavity having at least one overhanging zone (26), which partially covers one edge of the substrate, such as to limit the displacement of this micromodule towards the exterior of the cavity, characterised in that the overhanging zone (26) is limited to corners of the cavity, the latter having a rectangular or square shape.

2. Chip card according to claim 1, characterised in that the overhang is limited to two corners of the cavity, these corners being aligned according to a direction which is adjacent to a diagonal of the card.

3. Chip card according to one of claims 1 and 2, characterised in that the card is made by pressing superimposed sheets of plastics material (10a to 10d), some of the sheets being cut in order to form the cavity (12), and the last sheet (10d) of the superimposition having a cut-out part with a specific shape, which defines the required overhang, relative to the cut-out part of the preceding sheet.

4. Chip card according to one of claims 1 to 3, characterised in that the overhangs are made of a slightly conductive material.

5. Method for production of a flat chip card, comprising a cavity (12), which is provided in the body (10) of the card, and a micromodule (14), which is accommodated in this cavity, the micromodule comprising two parts, i.e. firstly a flat isolating substrate (18), which is covered with galvanic connections (16), and secondly a block, which is formed by a chip (20), which is encased (24) and is secured to this substrate, the encased chip comprising an integrated circuit, which is connected to the connections of the substrate, the chip being of a specific size, the substrate surmounting the block, such that the connections are flush with the plane of the upper surface of the card, when the micromodule is fitted in the cavity, the substrate being of a size which is larger than the chip, the edges of the cavity having at least one overhanging zone (26), which partially covers one edge of the substrate, such as to limit the displacement of this micromodule towards the exterior of the cavity, characterised in that it consists of:
- moulding resin in order to define the cavity and a boss (28), the boss extending towards the top of this cavity, on one edge of the latter,
- then of compressing the boss above one edge of the substrate of the micromodule, after the latter has been put in place in the cavity, in order to form the overhanging zone.

6. Method according to claim 5, characterised in that the turned down overhangs are produced such as to have a configuration which permits removable clipping of the micromodule.

7. Method according to one of claims 5 to 6, characterised in that the turned down overhangs are made of a slightly conductive material.

8. Method according to one of claims 5 to 7, characterised in that the turned down overhangs are formed in corners of the cavity.
